(19) Europäisches Patentamt
European Patent Office
Office européen des brevets

(11) **EP 4 231 094 A1**

(12) **EUROPEAN PATENT APPLICATION**
published in accordance with Art. 153(4) EPC

(43) Date of publication:
**23.08.2023 Bulletin 2023/34**

(21) Application number: **21879996.3**

(22) Date of filing: **08.10.2021**

(51) International Patent Classification (IPC):
*G03F 1/24* (2012.01)     *C23C 14/14* (2006.01)

(52) Cooperative Patent Classification (CPC):
**C23C 14/14; G03F 1/24**

(86) International application number:
**PCT/JP2021/037350**

(87) International publication number:
**WO 2022/080257 (21.04.2022 Gazette 2022/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **14.10.2020   JP 2020173230**
**05.04.2021   JP 2021064242**

(71) Applicant: **Toppan Photomask Co., Ltd.**
**Tokyo 108-0023 (JP)**

(72) Inventors:
• **ICHIKAWA Kenjiro**
  **Tokyo 110-0016 (JP)**
• **GODA Ayumi**
  **Tokyo 110-0016 (JP)**
• **NAKANO Hideaki**
  **Tokyo 110-0016 (JP)**
• **YAMAGATA Yuto**
  **Tokyo 110-0016 (JP)**

(74) Representative: **Hoffmann Eitle**
**Patent- und Rechtsanwälte PartmbB**
**Arabellastraße 30**
**81925 München (DE)**

(54) **REFLECTIVE MASK AND METHOD FOR PRODUCING REFLECTIVE MASK**

(57)     The present invention provides a reflective mask capable of reducing the shadowing effect and having sufficient hydrogen radical resistance and a method for producing the reflective mask. A reflective mask (100) according to this embodiment includes: a substrate (11); a reflective film (12) reflecting an EUV light having a multi-layer film structure formed on the substrate (11); a protective film (13) formed on the reflective film (12) and protecting the reflective film (12); an absorption film pattern (14a) absorbing the EUV light formed on the protective film (13); and an oxide coating (15) formed on the absorption film pattern (14a), in which the absorption film pattern (14a) contains Sn and a metal element other than Sn and has a ratio of the atomic weight of Sn to the total atomic weight of the metal element other than Sn (Sn/Metal element other than Sn) within the range of 1 or more and less than 20 and the oxide coating (15) is resistant to hydrogen radicals and is formed on the surface and the side surfaces of the absorption film pattern (14a).

FIG. 1

**Description**

Technical Field

The present disclosure relates to a reflective mask and a method for producing a reflective mask.

Background Art

Conventionally, reflective masks which have enabled the miniaturization by photolithography by using an EUV exposure device using a short-wavelength EUV light have posed a problem referred to as a so-called "shadowing effect" in which the optical axis is tilted when the EUV light is incident, and therefore the incident EUV light creates a shadow of a photomask pattern (absorption film pattern), which deteriorates the transfer performance.
To address the problem, a reflective mask has been proposed which reduces the shadowing effect by enabling the formation of an absorption film having a film thickness smaller than before by using a material having a high extinction coefficient k for the absorption film and suppressing the EUV reflectance (See PTL 1, for example).

Citation List

Patent Literature

PTL 1: WO 2018/159785

Summary of Invention

Technical Problem

In the EUV exposure device, cleaning with hydrogen radicals is performed to prevent contamination inside a chamber due to contamination (mixing of impurities). More specifically, the reflective mask needs to be formed using materials resistant to hydrogen radical reduction. However, some materials having a high extinction coefficient k have low hydrogen radical resistance, which has posed a problem that reflective masks formed of the materials having low hydrogen radical resistance cannot withstand long-term use.
It is an object of the present disclosure to provide a reflective mask capable of reducing the shadowing effect and having sufficient hydrogen radical resistance and a method for producing the reflective mask.

Solution to Problem

To solve the above-described problems, a reflective mask according to one aspect of the present disclosure includes: a substrate; a reflective film reflecting an EUV light having a multi-layer film structure formed on the substrate; a protective film formed on the reflective film, and protecting the reflective film; an absorption film absorbing the EUV light formed on the protective film; and an oxide coating formed on the absorption film; in which the absorption film contains Sn and a metal element other than Sn and has a ratio of the atomic weight of the Sn to the total atomic weight of the metal element other than Sn (Sn/Metal element other than Sn) within the range of 1 or more and less than 20, and the oxide coating is resistant to a hydrogen radical and formed on the surface and the side surfaces of the absorption film.

Advantageous Effects of Invention

One aspect of the present disclosure can provide a reflective mask capable of reducing the shadowing effect and having sufficient hydrogen radical resistance and a method for producing the reflective mask.

Brief Description of Drawings

FIG. 1 is a cross-sectional view schematically illustrating one configuration example of a reflective mask according to this embodiment;
FIG. 2 is a graph showing the optical constant of each metal at the wavelength of an EUV light;
FIG. 3 is a conceptual view illustrating a method for evaluating hydrogen radical resistance according to this embodiment;

FIG. 4 is a schematic cross-sectional view illustrating a step of producing a reflective mask according to this embodiment;

FIG. 5 is a schematic cross-sectional view illustrating a step of producing the reflective mask according to this embodiment;

FIG. 6 is a schematic cross-sectional view illustrating a step of producing the reflective mask according to this embodiment;

FIG. 7 is a schematic cross-sectional view illustrating a step of producing the reflective mask according to this embodiment; and

FIG. 8 is a schematic cross-sectional view illustrating a step of producing the reflective mask according to this embodiment.

Description of Embodiments

One embodiment of the present disclosure will now be described with reference to the drawings.

Herein, the drawings are schematic, and the relationship between the thickness and the plane dimension, the thickness ratio of each layer, and the like are different from the actual relationship, ratio, and the like. The embodiment described below exemplifies configurations for embodying the technical idea of the present disclosure. The technical idea of the present disclosure does not specify materials, shapes, structures, and the like of constituent components to the materials, shapes, structures, and the like described below. The technical idea of the present disclosure can be variously altered within the technical range defined by Claims.

(Configuration of reflective mask)

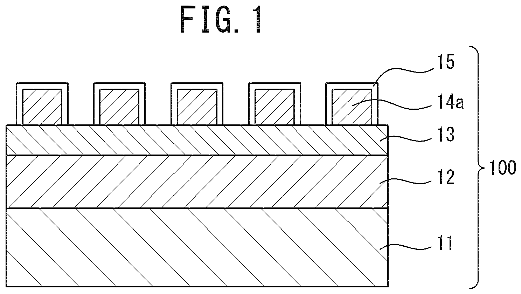

The basic configuration of a reflective mask according to one embodiment of the present disclosure is described using FIG. 1. FIG. 1 is a cross-sectional view for describing one configuration example of a reflective photomask (reflective mask) 100 according to the embodiment of the present disclosure.

As illustrated in FIG. 1, the reflective photomask 100 according to one embodiment of the present disclosure has a multi-layer reflective film 12, a protective film 13, and an absorption film pattern 14a deposited in this order on one surface side of a substrate 11. The absorption film pattern 14a is formed by patterning an absorption film 14 described later. Further, an oxide coating 15 is formed on the surface and the side surfaces of the absorption film pattern 14a. Hereinafter, each layer is described in detail.

(Substrate)

The substrate 11 is a layer serving as a base of the reflective photomask 100. For the substrate 11 according to this embodiment, a flat Si substrate, synthetic quartz substrate, or the like is usable. Further, a low thermal expansion glass to which titanium is added is usable for the substrate 11. However, this embodiment is not limited to the above insofar as materials have a small thermal expansion coefficient.

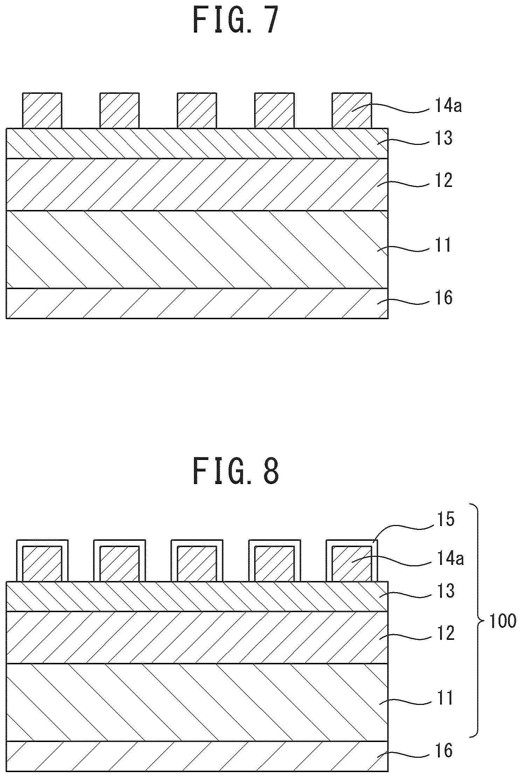

As illustrated in FIG. 8, a back surface conductive film 16 can be formed on the surface on which the multi-layer reflective film 12 is not formed of the substrate 11. The back surface conductive film 16 is a film for fixing the reflective photomask 100 utilizing the principle of an electrostatic chuck when the reflective photomask 100 is installed in an exposure machine.

(Multi-layer reflective film)

The multi-layer reflective film 12 is a layer having a multi-layer film structure formed on the substrate 11 and is a layer provided to reflect an EUV light (extreme ultraviolet light) which is an exposure light in the reflective photomask 100.

The multi-layer reflective film 12 contains a plurality of reflective films containing a combination of materials having greatly different refractive indices to the EUV light. For example, the multi-layer reflective film 12 can be formed by repeatedly depositing a layer containing a combination of Mo (molybdenum) and Si (silicon) or Mo (molybdenum) and Be (beryllium) by about 40 cycles.

(Protective film)

The protective film 13 is a layer formed on the multi-layer reflective film 12 and is a layer functioning as an etching stopper to prevent damage to the multi-layer reflective film 12 in forming the absorption film pattern 14a by etching. The protective film 13 may not be provided depending on materials of the multi-layer reflective film 12 and etching conditions. The protective film 13 according to this embodiment is formed of a material resistant to dry etching performed in pattern formation of an absorption film 14.

(Absorption film)

The absorption film 14 is a layer formed on the protective film 13 and is a layer absorbing the EUV light which is an exposure light in the reflective photomask 100. The absorption film 14 is a layer forming an absorption layer pattern (transfer pattern) which is a fine pattern for transfer.

As illustrated in FIG. 1, an absorption pattern (absorption film pattern 14a) of the reflective photomask 100 is formed by removing a part of the absorption film 14 of a reflective photomask blank, i.e., patterning the absorption film 14. In the EUV lithography, the EUV light is obliquely incident and reflected by the multi-layer reflective film 12, but the transfer performance onto a wafer (semiconductor substrate) sometimes deteriorates due to a shadowing effect in which the absorption film pattern 14a interferes with an optical path. This deterioration of the transfer performance is reduced by reducing the thickness of the absorption film pattern 14a absorbing the EUV light. The thickness of the absorption film pattern 14a can be reduced by applying a material having higher absorptivity to the EUV light than that of a conventional material, i.e., a material having a high extinction coefficient k to a wavelength of 13.5 nm.

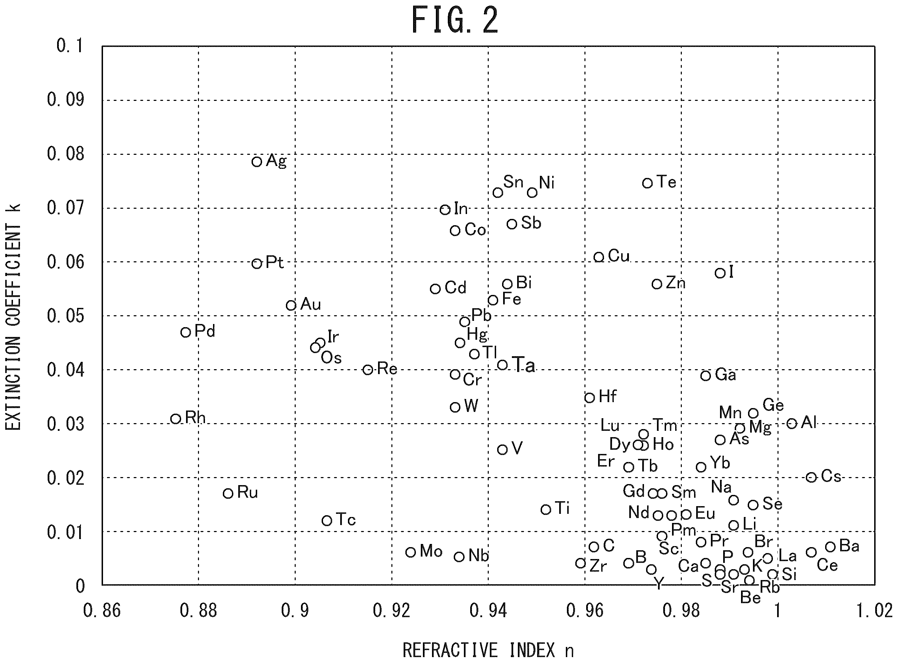

FIG. 2 is a graph showing the optical constant to the wavelength of 13.5 nm of the EUV light of each metal material. The horizontal axis of FIG. 2 represents the refractive index n and the vertical axis represents the extinction coefficient k. The extinction coefficient k of tantalum (Ta), which is a main material of the conventional absorption film 14, is 0.041. Compound materials having the extinction coefficient k larger than that of tantalum (Ta) can reduce the thickness of the absorption film 14 as compared with conventional compound materials. By the use of materials having the extinction coefficient k of 0.06 or more as the main ingredient, the thickness of the absorption film 14 can be sufficiently reduced, and thus the shadowing effect can be reduced.

As materials satisfying a combination of the optical constants (nk value) described above, silver (Ag), indium (In), tin (Sn), nickel (Ni), tellurium (Te), and the like are present, for example, and their extinction coefficients k are within the range of 0.07 to 0.08 as illustrated in FIG. 2. In the case of the materials above, the extinction coefficients k can be significantly increased to about twice the extinction coefficient 0.041 of tantalum (Ta), which is a conventional absorption film material, and therefore high light absorptivity is obtained. However, most of these materials having high light absorptivity are difficult to be processed into a reflective mask due to poor dry etching properties (in other words, halides of these elements have low volatility), and thus have poor practicality as a reflective mask. In contrast to these materials, Sn, which has the high extinction coefficient k, is an absorption film material having a high dry etching rate with respect to a fluorine-based gas or a chlorine-based gas and having good processability. In an EUV exposure device provided with a reflective photomask, when the photomask is exposed to a hydrogen radical environment, a simple Sn substance reacts with the hydrogen radicals and is converted to gaseous $SnH_4$, which causes a film reduction of the absorption film pattern 14a. As a countermeasure against the above, the life of the photomask can be prolonged by covering the surface and the side surfaces of the absorption film pattern 14a with the oxide coating 15 described later.

For the absorption film 14, compound materials containing Sn and a metal element M other than Sn are usable. The absorption film 14 preferably has a ratio of the atomic weight of Sn, which is the main ingredient, to the total atomic weight of the metal element M other than Sn (hereinafter also simply referred to as "Sn/M") of 1 or more. When Sn/M in the absorption film 14 is 1 or more, the shadowing effect can be reduced and the transfer performance can be improved. In this embodiment, the "main ingredient" means an element (ingredient) having the largest content ratio among elements (ingredients) constituting the absorption film 14.

Further, for the absorption film 14, compound materials containing at least one of Cr, Ta, Nb, Ti, Al, V, and Hf are usable as the metal element M other than Sn. The mixing ratio of these compounds needs to be a mixing ratio at which the oxide coating 15 having hydrogen radical resistance is stably formed. Therefore, the mixing ratio of the compound materials (metal element M other than Sn) in the absorption film 14 needs to be less than 20 at maximum in terms of the Sn/M ratio above. More specifically, Sn/M in the absorption film 14 is desirably less than 20 to stably form the oxide coating 15 having hydrogen radical resistance. Further, Sn/M in the absorption film 14 is more preferably within the range of 2 or more and 6 or less. When the content of the compound materials (metal element M other than Sn) in the absorption film 14 is adjusted such that Sn/M is 2 or more and 6 or less, the oxide coating 15 can be more stably formed.

Further, the absorption film 14 may contain Sn in a proportion of 50 at% or more. Due to the fact that the absorption film 14 contains Sn in a proportion of 50 at% or more, the shadowing effect can be reduced and the transfer performance can be improved.

Even when the absorption film 14 contains Sn in a proportion of 50 at% or more, the above-described compound materials containing the metal element M other than Sn, i.e., at least one of Cr, Ta, Nb, Ti, Al, V, and Hf, can be added to the absorption film 14. The mixing ratio of the compound materials (metal element M other than Sn) in the absorption film 14 containing Sn in a proportion of 50 at% or more needs to be larger than 5 at% and more preferably 15 at% or more with respect to the total atomic weight of the absorption film 14. When the absorption film 14 contains the compound materials in a proportion of more than 5 at%, the oxide coating 15 can be stably formed. When the absorption film 14 contains the compound materials in a proportion of 15 at% or more, the oxide coating 15 can be more stably formed.

As the metal element M other than Sn, Cr, Nb, and Hf among the elements mentioned above are more preferable because Cr, Nb, and Hf form a stable oxide coating.

The absorption film 14 may contain at least one element selected from B, P, C, Si, and Ge as metalloid elements in addition to the elements mentioned above. By compounding these elements (metalloid elements) in the absorption film 14, the oxide coating 15 can be more stably formed. When the content of these elements is larger than the total atomic weight of the metal element M other than Sn, the formation of the oxide coating 15 becomes unstable, and therefore the content of these elements needs to be lower than the total atomic weight of the metal element M other than Sn. More specifically, with respect to a ratio of the total atomic weight of a metalloid element L to the total atomic weight of the metal element M other than Sn (hereinafter also simply referred to as "L/M"), L/M is desirably within the range of 0 or more and 1 or less and more preferably within the range of 0.1 or more and 0.5 or less to stably form the oxide coating 15. When L/M in the absorption film 14 is within the ranges above, the oxide coating 15 can be more stably formed.

The absorption film 14 may not contain the metalloid elements mentioned above. In that case, L/M, which is the ratio of the total atomic weight of the metalloid element L to the total atomic weight of the metal element M other than Sn, is 0.

Among the elements mentioned above, B, P, and Si are more preferable as the metalloid elements, and P is the most preferable because an oxide coating can be quickly formed.

Further, the absorption film 14 contains, for example, O or N as elements other than the metal element M other than Sn and the metalloid element L when Sn/M and L/M are within the numerical value ranges above.

The absorption film 14 needs to be a material that can be etched with a fluorine-based gas or a chlorine-based gas to form a fine pattern. Sn, Cr, Ta, Nb, Ti, Al, V, Hf, B, P, C, Si, and Ge, which are materials capable of constituting the absorption film 14, are materials that can be etched with a fluorine-based gas or a chlorine-based gas and can finely form the absorption film pattern 14a.

Herein, an optical density (OD) value, which is an index representing the contrast of the light intensities of the multi-layer reflective film 12 and the absorption film 14, is described. When the intensity of a reflected light from the multi-layer reflective film 12 is defined as Rm and the intensity of a reflected light from the absorption film 14 is defined as Ra, the OD value is defined by Expression (1) below.

$$OD = -\log(Ra/Rm) \qquad \cdots \text{Equation (1)}$$

When the OD value is larger, the contrast is better and higher transferability is obtained. Although OD > 1 is required for the pattern transfer in the reflective photomask, the OD value of 1.5 or more is more preferable to obtain transfer performance higher than that of conventional films.

The film thickness of the absorption film 14 (absorption film pattern 14a) is preferably 45 nm or less. When the film thickness of the absorption film 14 is 45 nm, the shadowing effect can be reduced and the transfer performance can be improved. The absorption film 14 preferably has a mixing ratio calculated such that the OD value is 1 or more to maintain a contrast that enables pattern transfer.

(Oxide coating)

The oxide coating 15 is a film resistant to hydrogen radicals and formed on the surface and the side surfaces of the absorption film pattern 14a. More specifically, the oxide coating 15 is a film formed to cover exposed parts of the absorption film pattern 14a.

The oxide coating 15 can be formed by forming the absorption film pattern 14a, and then oxidizing the surface of the absorption film pattern 14a, for example. Therefore, the absorption film 14 preferably contains a compound containing at least one of Cr, Ta, Nb, Ti, Al, V, and Hf. When the absorption film 14 contains the compound containing at least one of Cr, Ta, Nb, Ti, Al, V, and Hf, the compound containing at least one of Cr, Ta, Nb, Ti, Al, V, and Hf can be easily added to the oxide coating 15.

As described above, the oxide coating 15 preferably contains a compound containing at least one of oxides of Cr, Ta, Nb, Ti, Al, V, and Hf. Among the elements described above, Cr, Nb, and Hf are more preferable because Cr, Nb, and Hf form a stable oxide coating.

The oxide coating 15 may not contain Sn. It may be acceptable that the oxide coating 15 contains Sn, and the content of the Sn is smaller than the content of the compound containing at least one of oxides of Cr, Ta, Nb, Ti, Al, V, and Hf.

Methods for forming the oxide coating 15 include methods in wet processes using chemical solutions represented by chemical treatment with chemical solutions, such as nitric acid or sulfuric acid, or electrochemical treatment, such as anode polarization in chemical solutions, such as nitric acid or sulfuric acid, or in dry processes using an oxidizing gas, such as oxygen plasma. Chemical solutions or gases other than those mentioned above may be used to form the oxide coating 15, and several methods may be combined.

Current EUV exposure devices are cleaned with hydrogen radicals to prevent the contamination inside a chamber due to contamination. Therefore, when reflective photomasks have low durability to hydrogen radicals, the life of the masks is shortened. To prolong the life of the reflective photomasks, the reflective photomasks need to be formed of compound materials having high hydrogen radical resistance. Sn used as a material for the absorption film 14 has the high extinction coefficient k but has a problem that a simple Sn substance reacts with hydrogen radicals in the hydrogen radical environment and is converted to gaseous $SnH_4$, which causes the film reduction of the absorption film pattern 14a.

To use the reflective photomasks in the hydrogen radical environment, Sn may not be directly exposed to the hydrogen radicals. Specifically, when the oxide coating 15 formed of materials resistant to hydrogen radicals is present on the surface of the absorption film pattern 14a containing Sn, Sn is not exposed to the hydrogen radicals, which enables the long-term use thereof in the hydrogen radical environment, for example.

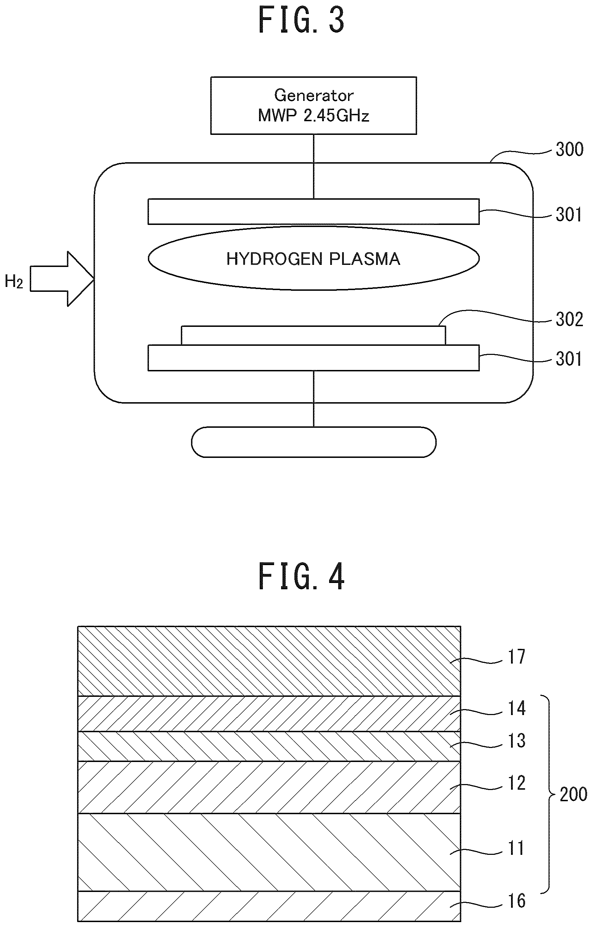

The materials resistant to the hydrogen radicals are preferably compound materials exhibiting a film reduction of 1 nm or less in the hydrogen radical environment excited under a condition that the distance between electrodes 301 was set to 18 mm using a 2.45 GHz micro wave plasma (MWP) at a hydrogen flow rate of 100 sscm using an apparatus illustrated in FIG. 3. In FIG. 3, a sample (test target) is denoted by "302" and a chamber is denoted by "300".

Materials forming the oxide coating 15 having hydrogen radical resistance include oxides of Cr, Ta, Nb, Ti, Al, V, and Hf. The oxide coating may contain elements inert to hydrogen radicals, such as F, as elements other than the metal elements mentioned above and O.

The elements forming the oxide coating 15 are materials that are susceptible to oxidation, and therefore the surface of the absorption film 14 is sometimes naturally oxidized. These oxide films are very stable materials, and therefore the etching rate deteriorates, which is disadvantageous for the formation of fine patterns in some cases. In that case, a hard mask layer for preventing the natural oxidation may be provided on the absorption film 14, for example.

Materials used for the hard mask layer are preferably materials, such as $SiO_2$, SiON, TaO, TaN, TaBN, CrN, CrON, and CrO.

The film thickness of the oxide coating 15 is preferably 1 nm or more and 10 nm or less. When the film thickness of the oxide coating 15 is 1 nm or more, stable hydrogen radical resistance can be provided. When the film thickness of the oxide coating 15 is 10 nm or less, it is possible to reduce the shadowing effect or suppress the influence on the optical properties, such as EUV reflectance and contrast, of the absorption film 14. The film thickness of the oxide coating 15 is more preferably 2 nm or more and 5 nm or less because the best balance between the radical resistance and a change in the optical properties is achieved.

The total film thickness of the absorption film 14 and the oxide coating 15 is more preferably 45 nm or less. When the total film thickness of the absorption film 14 and the oxide coating 15 is 45 nm or less, the shadowing effect can be reduced and the transfer performance can be improved. To maintain the contrast that enables pattern transfer, the absorption film 14 and the oxide coating 15 may be set to have an OD value of 1 or more as a whole.

Herein, to evaluate the influence of the shadowing effect, it was compared by a simulation how an HV bias value changes when each of absorption films was used, the absorption films each having a $TiO_2$ oxide coating (film thickness of 5 nm) formed on an existing Ta film (deposited film including a TaN layer for the lower layer and a TaO layer for the upper layer: film thickness of 60 nm) and on an Sn film containing Ti (film thickness of 40 nm). The HV bias value is a line width difference of a transfer pattern depending on the direction of a mask pattern, i.e., a difference between the line width in the horizontal (H) direction and the line width in the vertical (V) direction. The line width in the H direction indicates the line width of a linear pattern orthogonal to a plane formed by an incident light and a reflected light (hereinafter sometimes referred to as "incident plane"). The line width in the V direction indicates the line width of a linear pattern parallel to the incident plane. More specifically, the line width in the H direction is the length in the direction parallel to the incident plane, and the line width in the V direction is the length in the direction orthogonal to the incident plane.

The line width in the H direction is affected by the shadowing effect, which results in a decrease in the contrast at edge parts of the transfer pattern or a decrease in the line width in the H direction. The pattern affected by the shadowing effect has a line width after transfer smaller than a desired line width. On the other hand, the line width in the V direction is hardly affected by the shadowing effect. Therefore, a line width difference (HV bias) is generated between the line width of the transfer pattern in the direction perpendicular to the incident plane and the line width of the transfer pattern in the direction parallel to the incident plane.

In the comparison of the HV bias values of the absorption films each having the $TiO_2$ oxide coating formed on the existing Ta film and the Sn film containing Ti, a tantalum (Ta) mask of Reference Example and a reflective photomask of Example 1 in Table 1 were used. When the HV bias values of the tantalum (Ta) mask of Reference Example and the reflective photomask of Example 1 were compared, the HV bias value of the Ta film is as extremely large as 7.3 nm, but the HV bias value of the absorption film having the $TiO_2$ coating formed on the Sn film containing Ti can be greatly reduced to 5.7 nm, which is improved, as shown in Table 1. As described above, it is found in the reflective photomask 100 of this embodiment that the influence (HV bias) of the shadowing effect can be greatly reduced by the use of the absorption film having the $TiO_2$ oxide coating 15 formed on the Sn film containing Ti for a formation material of the absorption film pattern 14a.

(Method for producing reflective photomask)

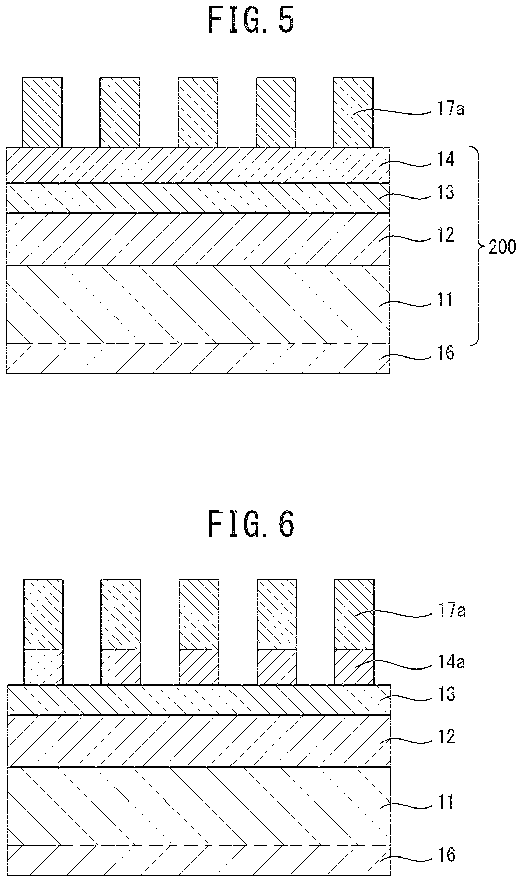

Next, a method for producing a reflective photomask (reflective mask) is described using FIGS. 4 to 8.
As illustrated in FIG. 4, a positive chemically amplified resist (SEBP9012: manufactured by Shin-Etsu Chemical Co., Ltd.) was formed by spin coating to have a film thickness of 120 nm on the absorption film 14 provided on a reflective photomask blank 200, and then baked at 110°C for 10 min to form a resist film 17.
Next, a predetermined pattern was drawn on the resist film 17 formed of the positive chemically amplified resist by an electron beam lithography machine (JBX3030: manufactured by JEOL). Thereafter, baking treatment was performed at 110°C for 10 minutes, followed by spray development (SFG3000: manufactured by Sigma Meltec). This formed a resist pattern 17a as illustrated in FIG. 5.
Next, as illustrated in FIG. 6, the absorption film 14 was patterned by dry etching mainly using a chlorine-based gas with the resist pattern 17a as an etching mask to form the absorption film pattern 14a.
Next, the remaining resist pattern 17a was peeled off, thereby exposing the absorption film pattern 14a as illustrated in FIG. 7. In this embodiment, the absorption film pattern 14a formed in the absorption film 14 was set to an LS (line and space) pattern having a line width of 64 nm. The LS pattern having a line width of 64 nm was designed in each of the x-direction and the y-direction such that the influence of the shadowing effect by the EUV irradiation can be easily seen.
Next, the surface of the absorption film pattern 14a was oxidized using a sulfuric acid solution having a weight concentration of 90% and a liquid temperature of 25°C to form the oxide coating 15 as illustrated in FIG. 8. At this time, the oxide coating 15 was formed on the surface and the side surfaces of the absorption film 14 to cover the exposed parts of the absorption film pattern 14a. Thus, the reflective photomask 100 according to this embodiment is produced.

<Effects of this embodiment>

The reflective photomask 100 according to this embodiment has the following effects.

(1) In the reflective photomask 100 of this embodiment, the absorption film 14 (absorption film pattern 14a) contains Sn and the metal element M other than Sn and has the ratio of the atomic weight of Sn to the total atomic weight of the metal element M other than Sn (Sn/Metal element M other than Sn) within the range of 1 or more and less than 20. According to this configuration, the shadowing effect can be reduced and the transfer performance can be improved.
(2) In the reflective photomask 100 of this embodiment, the oxide coating 15 has hydrogen radical resistance and is formed on the surface and the side surfaces of the absorption film 14.
According to this configuration, the reflective photomask 100 has radical resistance, and thus the life of the reflective photomask 100 can be prolonged.
(3) In the reflective photomask 100 of this embodiment, the absorption film 14 may contain the compound containing at least one of Cr, Ta, Nb, Ti, Al, V, and Hf. The absorption film 14 may contain the compound containing at least one of Cr, Ta, Nb, Ti, Al, V, and Hf in an amount larger than 5 at% of the total atomic weight of the absorption film 14.
According to this configuration, the oxide coating 15 having hydrogen radical resistance can be stably formed.
(4) In the reflective photomask 100 of this embodiment, the absorption film 14 may contain at least one of B, C, P, Si, and Ge as the metalloid element L. As the content of the metalloid element L, L/M may be within the range of 0 or more and 1 or less with respect to the total atomic weight of the metal element M other than Sn. It is a matter of course that, in the reflective photomask 100 of this embodiment, the absorption film 14 may not contain at least one of B, C, P, Si, and Ge as the metalloid element L.
According to this configuration, the oxide coating 15 having hydrogen radical resistance can be more stably formed.
(5) In the reflective photomask 100 of this embodiment, the absorption film 14 may be able to be etched with a fluorine-based gas or a chlorine-based gas.
According to this configuration, a fine pattern can be formed in the absorption film 14.
(6) In the reflective photomask 100 of this embodiment, the OD value may be 1.0 or more.
According to this configuration, the absorption film 14 can maintain the contrast that enables pattern transfer.
(7) In the reflective photomask 100 of this embodiment, the absorption film 14 may contain Sn in a proportion of 50 at% or more.
According to this configuration, the shadowing effect can be reduced and the transfer performance can be improved.
(8) In the reflective photomask 100 of this embodiment, the oxide coating 15 may contain the compound containing at least one of oxides of Cr, Ta, Nb, Ti, Al, V, and Hf.

According to this configuration, the oxide coating 15 having hydrogen radical resistance can be stably formed.

(9) In the reflective photomask 100 of this embodiment, the oxide coating 15 may not contain Sn. It may be acceptable that the oxide coating 15 contains Sn, and the content of Sn may be smaller than the content of the compound containing at least one of oxides of Cr, Ta, Nb, Ti, Al, V, and Hf.

According to this configuration, the oxide coating 15 having hydrogen radical resistance can be stably formed.

(10) In the reflective photomask 100 of this embodiment, the oxide coating 15 may have a film thickness of 1 nm or more.

According to this configuration, the oxide coating 15 having hydrogen radical resistance can be stably formed.

(11) In the reflective photomask 100 of this embodiment, the total film thickness of the absorption film 14 and the oxide coating 15 may be 45 nm or less.

According to this configuration, the shadowing effect can be reduced and the transfer performance can be improved.

Examples

Hereinafter, the present disclosure is described in more detail with respect to Examples but the present disclosure is not limited by Examples at all.

<Example 1>

A synthetic quartz substrate having low thermal expansion characteristics was used as a substrate. On the substrate, a multi-layer reflective film was formed by depositing 40 multi-layer films each containing a pair of silicon (Si) and molybdenum (Mo). The film thickness of the multi-layer reflective film was set to 280 nm.

Next, a protective film was formed using ruthenium (Ru) such that the film thickness was 2.5 nm on the multi-layer reflective film.

On the protective film, an absorption film was formed using tin (Sn) and titanium (Ti). At this time, the absorption film was formed such that the total film thickness with an oxide coating described later was 45 nm. The atomic number ratio of tin (Sn) and titanium (Ti) was 80.0:20.0 as measured by XPS (X-ray photoelectron spectroscopy). Therefore, it was found that Sn/M was 4 and L/M was 0. The measurement by an XRD (X-ray diffraction device) showed that the absorption film was amorphous although crystallinity was slightly observed.

Next, on the side where the multi-layer reflective film was not formed of the substrate, a back surface conductive film was formed using chromium nitride (CrN) such that the thickness was 100 nm.

For the formation of each film on the substrate, a multi-source sputtering apparatus was used. The film thickness of each film was controlled by a sputtering time.

Next, a positive chemically amplified resist (SEBP9012: manufactured by Shin-Etsu Chemical Co., Ltd.) was formed by spin coating to have a film thickness of 120 nm on the absorption film, and then baked at 110°C for 10 min to form a resist film.

Next, a predetermined pattern was drawn on the positive chemically amplified resist by an electron beam lithography machine (JBX3030: manufactured by JEOL).

Thereafter, baking treatment was performed at 110°C for 10 minutes, followed by spray development (SFG3000: manufactured by Sigma Meltec). This formed a resist pattern.

Next, the absorption film was patterned by dry etching mainly using a chlorine-based gas with the resist pattern as an etching mask to form an absorption film pattern.

Next, the remaining resist pattern was peeled off. Thus, an absorption film pattern was formed in which the surface and the side surfaces of the absorption film were exposed.

In this example, the absorption film pattern was set to an LS (line and space) pattern having a line width of 64 nm. The LS pattern having a line width of 64 nm was designed in each of the x-direction and the y-direction such that the influence of the shadowing effect by the EUV irradiation can be easily seen.

Next, an oxide coating was formed using a sulfuric acid solution having a weight concentration of 90% and a liquid temperature of 25°C. When the film thickness and the composition were confirmed with a transmission electron microscope (TEM), it was found that the oxide coating was formed such that the film thickness was 5 nm and the composition was Ti:O = 1:2 and that the total film thickness of the oxide coating and the absorption film was 45 nm. As described above, a reflective photomask of Example 1 was produced.

The absorption film of Example 1 was measured for a reflectance Rm of a multi-layer reflective film region and a reflectance Ra of an absorption film region with a reflectance measuring device using the EUV light. From the measurement results, the OD value, which is the mask characteristic, was calculated. As a result, it was found that the reflective photomask was produced such that the EUV reflectance was 0.72% and the OD value was 1.9 as shown in Table 1.

<Example 2>

The absorption film was formed by changing the material of the absorption film to tin (Sn) and chromium (Cr). At this time, the atomic number ratio of tin (Sn) and chromium (Cr) was set to 80.0:20.0. Therefore, it was found that Sn/M was 4 and L/M was 0. Consequently, the composition of the oxide coating was Cr:O = 2:3. A reflective photomask of Example 2 was produced in the same manner as in Example 1 except for the above.
The reflective photomask of Example 2 had the EUV reflectance of 0.50% and the OD value of 2.1.

<Example 3>

The absorption film was formed by changing the material of the absorption film to tin (Sn) and niobium (Nb). At this time, the atomic number ratio of tin (Sn) and niobium (Nb) was set to 80.0:20.0. Therefore, it was found that Sn/M was 4 and L/M was 0. Consequently, the composition of the oxide coating was Nb:O = 2:3. A reflective photomask of Example 3 was produced in the same manner as in Example 1 except for the above.
The reflective photomask of Example 3 had the EUV reflectance of 0.34% and the OD value of 2.3.

<Example 4>

The absorption film was formed by changing the material of the absorption film to tin (Sn) and tantalum (Ta). At this time, the atomic number ratio of tin (Sn) and tantalum (Ta) was set to 80.0:20.0. Therefore, it was found that Sn/M was 4 and L/M was 0. Consequently, the composition of the oxide coating was Ta:O = 2:5. A reflective photomask of Example 4 was produced in the same manner as in Example 1 except for the above.
The reflective photomask of Example 4 had the EUV reflectance of 0.34% and the OD value of 2.3.

<Example 5>

The absorption film was formed by changing the material of the absorption film to tin (Sn) and aluminum (Al). At this time, the atomic number ratio of tin (Sn) and aluminum (Al) was set to 80.0:20.0. Therefore, it was found that Sn/M was 4 and L/M was 0. Consequently, the composition of the oxide coating was Al:O = 2:3. A reflective photomask of Example 5 was produced in the same manner as in Example 1 except for the above.
The reflective photomask of Example 5 had the EUV reflectance of 0.25% and the OD value of 2.4.

<Example 6>

The absorption film was formed by changing the material of the absorption film to tin (Sn) and vanadium (V). At this time, the atomic number ratio of tin (Sn) and vanadium (V) was set to 80.0:20.0. Therefore, it was found that Sn/M was 4 and L/M was 0. Consequently, the composition of the oxide coating was V:O = 2:5. A reflective photomask of Example 6 was produced in the same manner as in Example 1 except for the above.
The reflective photomask of Example 6 had the EUV reflectance of 0.39% and the OD value of 2.2.

<Example 7>

The absorption film was formed by changing the material of the absorption film to tin (Sn) and hafnium (Hf). At this time, the atomic number ratio of tin (Sn) and hafnium (Hf) was set to 80.0:20.0. Therefore, it was found that Sn/M was 4 and L/M was 0. Consequently, the composition of the oxide coating was Hf:O = 1:2. A reflective photomask of Example 7 was produced in the same manner as in Example 1 except for the above.
The reflective photomask of Example 7 had the EUV reflectance of 0.44% and the OD value of 2.2.

<Example 8>

The absorption film was formed by changing the material of the absorption film to tin (Sn) and hafnium (Hf). At this time, the atomic number ratio of tin (Sn) and hafnium (Hf) was set to 95.0:5.0. Therefore, it was found that Sn/M was 19 and L/M was 0. Consequently, the composition of the oxide coating was Hf:Sn:O = 1:1:2 and an oxide coating containing only $HfO_2$ was not formed. A reflective photomask of Example 8 was produced in the same manner as in Example 1 except for the above.
The reflective photomask of Example 8 had the EUV reflectance of 0.25% and the OD value of 2.4.

<Example 9>

The absorption film was formed by changing the material of the absorption film to tin (Sn) and titanium (Ti). At this time, the atomic number ratio of tin (Sn) and titanium (Ti) was set to 93.8:6.2. Therefore, it was found that Sn/M was 15 and L/M was 0. Consequently, the composition of the oxide coating was Ti:Sn:O = 1:1:2 and an oxide coating containing only $TiO_2$ was not formed. A reflective photomask of Example 9 was produced in the same manner as in Example 1 except for the above.

The reflective photomask of Example 9 had the EUV reflectance of 0.36% and the OD value of 2.3.

<Example 10>

The absorption film was formed by changing the material of the absorption film to tin (Sn), titanium (Ti), and boron (B). At this time, the atomic number ratio of tin (Sn), titanium (Ti), and boron (B) was set to 90.9:6.1:3.0. Therefore, it was found that Sn/M was 15 and L/M was 0.5. Consequently, the composition of the oxide coating was Ti:O = 1:2. A reflective photomask of Example 10 was produced in the same manner as in Example 1 except for the above.

The reflective photomask of Example 10 had the EUV reflectance of 0.42% and the OD value of 2.2.

<Example 11>

The absorption film was formed by changing the material of the absorption film to tin (Sn), titanium (Ti), and carbon (C). At this time, the atomic number ratio of tin (Sn), titanium (Ti), and carbon (C) was set to 90.9:6.1:3.0. Therefore, it was found that Sn/M was 15 and L/M was 0.5. Consequently, the composition of the oxide coating was Ti:O = 1:2. A reflective photomask of Example 11 was produced in the same manner as in Example 1 except for the above.

The reflective photomask of Example 11 had the EUV reflectance of 0.42% and the OD value of 2.2.

<Example 12>

The absorption film was formed by changing the material of the absorption film to tin (Sn), titanium (Ti), and phosphorus (P). At this time, the atomic number ratio of tin (Sn), titanium (Ti), and phosphorus (P) was set to 90.9:6.1:3.0. Therefore, it was found that Sn/M was 15 and L/M was 0.5. Consequently, the composition of the oxide coating was Ti:O = 1:2. A reflective photomask of Example 12 was produced in the same manner as in Example 1 except for the above.

The reflective photomask of Example 12 had the EUV reflectance of 0.43% and the OD value of 2.2.

<Example 13>

The absorption film was formed by changing the material of the absorption film to tin (Sn), titanium (Ti), and silicon (Si). At this time, the atomic number ratio of tin (Sn), titanium (Ti), and silicon (Si) was set to 90.9:6.1:3.0. Therefore, it was found that Sn/M was 15 and L/M was 0.5. Consequently, the composition of the oxide coating was Ti:O = 1:2. A reflective photomask of Example 13 was produced in the same manner as in Example 1 except for the above.

The reflective photomask of Example 13 had the EUV reflectance of 0.43% and the OD value of 2.2.

<Example 14>

The absorption film was formed by changing the material of the absorption film to tin (Sn), titanium (Ti), and oxygen (O). At this time, the atomic number ratio of tin (Sn), titanium (Ti), and oxygen (O) was set to 27.4:6.8:65.8. Therefore, it was found that Sn/M was 4 and L/M was 0. Consequently, the composition of the oxide coating was Ti:O = 1:2. A reflective photomask of Example 14 was produced in the same manner as in Example 1 except for the above.

The reflective photomask of Example 14 had the EUV reflectance of 0.60% and the OD value of 2.0.

<Example 15>

The absorption film was formed by changing the material of the absorption film to tin (Sn), titanium (Ti), boron (B), and oxygen (O). At this time, the atomic number ratio of tin (Sn), titanium (Ti), boron (B), and oxygen (O) was set to 28.8:4.8:1.0:65.4. Therefore, it was found that Sn/M was 6 and L/M was 0.2. Consequently, the composition of the oxide coating was Ti:O = 1:2. A reflective photomask of Example 15 was produced in the same manner as in Example 1 except for the above.

The reflective photomask of Example 15 had the EUV reflectance of 0.54% and the OD value of 2.1.

<Example 16>

The absorption film was formed by changing the material of the absorption film to tin (Sn) and bismuth (Bi). At this time, the atomic number ratio of tin (Sn) and bismuth (Bi) was set to 80.0:20.0. Therefore, it was found that Sn/M was 4 and L/M was 0. Consequently, the composition of the oxide coating was Bi:O = 2:3. A reflective photomask of Example 16 was produced in the same manner as in Example 1 except for the above.
The reflective photomask of Example 16 had the EUV reflectance of 0.19% and the OD value of 2.5.

<Example 17>

The absorption film was formed by changing the material of the absorption film to tin (Sn) and titanium (Ti). At this time, the atomic number ratio of tin (Sn) and titanium (Ti) was set to 93.8:6.2. Therefore, it was found that Sn/M was 15 and L/M was 0. Further, the oxide coating was formed using a sulfuric acid solution having a weight concentration of 60% and a liquid temperature of 25°C. Consequently, the composition of the oxide coating was Ti:Sn:O = 1:2:4 and an oxide coating containing only $TiO_2$ was not formed. A reflective photomask of Example 17 was produced in the same manner as in Example 1 except for the above.
The reflective photomask of Example 17 had the EUV reflectance of 0.36% and the OD value of 2.3.

<Example 18>

The absorption film was formed by changing the material of the absorption film to tin (Sn), titanium (Ti), and boron (B). At this time, the atomic number ratio of tin (Sn), titanium (Ti), and boron (B) was set to 86.7:5.8:7.5. Therefore, it was found that Sn/M was 15 and L/M was 1.3. Consequently, the film thickness of the oxide coating was 2 nm and the composition of the oxide coating was Ti:Sn:O = 1:1:2. A reflective photomask of Example 18 was produced in the same manner as in Example 1 except for the above.
The reflective photomask of Example 18 had the EUV reflectance of 0.27% and the OD value of 2.4

<Comparative Example 1>

The absorption film was formed by changing the material of the absorption film to tin (Sn) and titanium (Ti). At this time, the atomic number ratio of tin (Sn) and titanium (Ti) was set to 30.0:70.0. Therefore, it was found that Sn/M was 0.4 and L/M was 0. Consequently, the composition of the oxide coating was Ti:O = 1:2. A reflective photomask of Comparative Example 1 was produced in the same manner as in Example 1 except for the above.
The reflective photomask of Comparative Example 1 had the EUV reflectance of 5.40% and the OD value of 1.1.

<Comparative Example 2>

The absorption film was formed by changing the material of the absorption film to tin (Sn), titanium (Ti), and boron (B). At this time, the atomic number ratio of tin (Sn), titanium (Ti), and boron (B) was set to 66.7:11.1:22.2. Therefore, it was found that Sn/M was 6 and L/M was 2. An oxide coating containing titanium oxide was not formed. A reflective photomask of Comparative Example 2 was produced in the same manner as in Example 1 except for the above.
The reflective photomask of Comparative Example 2 had the EUV reflectance of 0.58% and the OD value of 2.0.

<Comparative Example 3>

The absorption film was formed by changing the material of the absorption film to tin (Sn) and titanium (Ti). At this time, the atomic number ratio of tin (Sn) and titanium (Ti) was set to 95.2:4.8. Therefore, it was found that Sn/M was 20 and L/M was 0. An oxide coating containing titanium oxide was not formed. A reflective photomask of Comparative Example 3 was produced in the same manner as in Example 1 except for the above.
The reflective photomask of Comparative Example 3 had the EUV reflectance of 0.02% and the OD value of 3.5.

<Evaluation>

The reflective photomasks obtained in Examples 1 to 18 and Comparative Examples 1 to 3 above were evaluated for the transfer performance and the hydrogen radical resistance by the following methods. The transfer performance was confirmed by wafer exposure evaluation. The above-described "existing tantalum (Ta) mask" is indicated as "Reference Example" in Table 1.

[Wafer exposure evaluation]

The absorption film pattern of the reflective photomask produced in each of Examples and Comparative Examples was transferred and exposed onto a semiconductor wafer coated with an EUV positive chemically amplified resist using an EUV exposure device (NXE3300B: manufactured by ASML). At this time, the exposure amount was adjusted such that the LS pattern in the x-direction was transferred as designed. Thereafter, the observation and the line width measurement of the transferred resist pattern were carried out with an electron beam dimension measuring machine, and the resolution and the HV bias were confirmed from the measurement results.

<Evaluation criteria>

The evaluation was performed based on the size (Large or Small) of the HV bias in comparison with a case where the existing tantalum (Ta) mask was used. More specifically, a case where the LS pattern in the y-direction was transferred as designed in a state where the adjustment was performed such that the LS pattern in the x-direction was transferred as designed and the HV bias was smaller than that when the existing tantalum (Ta) mask was used was evaluated as "Pass". A case where the LS pattern in the y-direction was not transferred as designed (LS pattern in the y-direction was not resolved) in a state where the adjustment was performed such that the LS pattern in the x-direction was transferred as designed or a case where the HV bias is larger than that when the existing tantalum (Ta) mask was used was evaluated as "Failure"

[Hydrogen radical resistance]

Hydrogen at a flow rate of 100 sscm was excited using a 2.45 GHz micro wave plasma (MWP), and the produced reflective photomask was placed on one of electrodes with an inter-electrode distance of 18 mm. A change in the film thickness of the absorption film after the hydrogen radical treatment was confirmed using an atomic force microscopy (AFM) and was evaluated in the following three grades of ◎, ○, and ×. The measurement was performed with a LS pattern having a line width of 200 nm.

<Evaluation criteria>

◎: No change in film thickness to hydrogen radicals was observed.
○: A slight change in film thickness to hydrogen radicals was observed.
×: A change in film thickness to hydrogen radicals was observed.

Further, in the column of "Mask characteristic" in Table 1, the evaluation was performed in the following three grades of ◎, Δ, and × from the viewpoint of the OD value and the transferability compared with those of the existing tantalum (Ta) mask.

<Evaluation criteria>

◎: Superiority was found in terms of both the OD value and the transferability.
Δ: Superiority was not found in terms of either the OD value or the transferability.
×: Both the OD value and the transferability were inferior.

In the column of "Determination" in Table 1, the evaluation was performed in the following four grades of ◎, ○, Δ, and ×.

<Evaluation criteria>

◎: Both the mask characteristic and the hydrogen radical resistance were evaluated as ◎.
○: The mask characteristic was evaluated as ◎ and the hydrogen radical resistance was evaluated as ○.
Δ: The mask characteristic was evaluated as Δ and the hydrogen radical resistance was evaluated as ◎ or ○.

×: Either or both the mask characteristic or/and the hydrogen radical resistance was/were evaluated as ×.

The evaluation results above are shown in Table 1.

[Table 1]

| | Absorption film | | Oxide coating | | Total film thickness (nm) of absorption film and oxide coating | Optical characteristics | | Evaluation | | | | | |
|---|---|---|---|---|---|---|---|---|---|---|---|---|---|
| | Materials (Sn/M, L/M) | Film thick-ness (nm) | Material | Film thick-ness (nm) | | Reflectance (%) | OD val-ue | x-direction dimension (nm) | y-direction dimension (nm) | HV bias (nm) | Mack charac-teristic | Hydrogen radical re-sistance | Determination |
| Ex. 1 | Sn + Ti (4, 0) | 40 | TiO2 | 5 | 45 | 0.72 | 1.9 | 16.0 | 10.3 | 5.7 | ◎ | ◎ | ◎ |
| Ex. 2 | Sn + Cr (4, 0) | 40 | Cr2O3 | 5 | 45 | 0.50 | 2.1 | 16.0 | 9.8 | 6.2 | ◎ | ◎ | ◎ |
| Ex. 3 | Sn + Nb (4, 0) | 40 | Na2O3 | 5 | 45 | 0.34 | 2.3 | 16.0 | 10.7 | 5.3 | ◎ | ◎ | ◎ |
| Ex. 4 | Sn + Ta (4, 0) | 40 | Ta2O5 | 5 | 45 | 0.34 | 2.3 | 16.0 | 10.4 | 5.6 | ◎ | ◎ | ◎ |
| Ex. 5 | Sn +Al (4, 0) | 40 | Al2O3 | 5 | 45 | 0.25 | 2.4 | 16.0 | 10.9 | 5.1 | ◎ | ◎ | ◎ |
| Ex. 6 | Sn +V (4, 0) | 40 | V2O5 | 5 | 45 | 0.39 | 2.2 | 160 | 10.5 | 5.5 | ◎ | ◎ | ◎ |
| Ex. 7 | Sn + Hf (4, 0) | 40 | HfO2 | 5 | 45 | 0.44 | 2.2 | 16.0 | 102 | 5.8 | ◎ | ◎ | ◎ |
| Ex. 8 | Sn + Hf (19, 0) | 40 | Hf + Sn + O | 5 | 45 | 0.25 | 2.4 | 16.0 | 102 | 5.8 | ◎ | ○ | ○ |
| Ex. 9 | Sn + Ti (15, 0) | 40 | Ti +Sn + O | 5 | 45 | 0.36 | 2.3 | 16.0 | 10.1 | 5.9 | ◎ | ○ | ○ |
| Ex. 10 | Sn + Ti + B (15, 0.5) | 40 | TiO2 | 5 | 45 | 0.42 | 2.2 | 16.0 | 10.1 | 5.9 | ◎ | ◎ | ◎ |
| Ex. 11 | Sn +Ti + C (15, 0.5) | 40 | TiO2 | 5 | 45 | 0.42 | 2.2 | 16.0 | 100 | 60 | ◎ | ◎ | ◎ |
| Ex. 12 | Sn + Ti + P (15, 0.5) | 40 | TiO2 | 5 | 45 | 0.43 | 2.2 | 16.0 | 10.1 | 5.9 | ◎ | ◎ | ◎ |
| Ex. 13 | Sn +Ti + Si (15, 0.5) | 40 | TiO2 | 5 | 45 | 0.43 | 2.2 | 16.0 | 10.1 | 5.9 | ◎ | ◎ | ◎ |

14

EP 4 231 094 A1

(continued)

| | Absorption film | | Oxide coating | | Total film thickness (nm) of absorption film and oxide coating | Optical characteristics | | Evaluation | | | | | |
|---|---|---|---|---|---|---|---|---|---|---|---|---|---|
| | Materials (Sn/M, L/M) | Film thickness (nm) | Material | Film thickness (nm) | | Reflectance (%) | OD value | x-direction dimension (nm) | y-direction dimension (nm) | HV bias (nm) | Mack characteristic | Hydrogen radical resistance | Determination |
| Ex. 14 | Sn + Ti + O (4, 0) | 40 | TiO2 | 5 | 45 | 0.60 | 2.0 | 16.0 | 10.1 | 5.9 | ◎ | ◎ | ◎ |
| Ex. 15 | Sn + Ti + B + O (6, 0.2) | 40 | TiO2 | 5 | 45 | 054 | 2.1 | 16.0 | 10.1 | 5.9 | ◎ | ◎ | ◎ |
| Ex. 16 | Sn + Bi (4, 0) | 40 | Bi2O3 | 5 | 45 | 0.19 | 2.5 | 16.0 | 9.3 | 6.7 | ◎ | ○ | ○ |
| Ex. 17 | Sn +Ti (15, 0) | 40 | Ti +Sn + O (Sn > Ti) | 5 | 45 | 0.36 | 2.3 | 16.0 | 10.1 | 5.9 | ◎ | ○ | ○ |
| Ex. 18 | Sn + Ti + B (15, 1.3) | 40 | Ti +Sn + O | 2 | 42 | 0.27 | 2.4 | 16.0 | 9.9 | 6.1 | ◎ | ○ | ○ |
| Comp. Ex. 1 | Sn + Ti (0.4, 0) | 40 | TiO2 | 5 | 45 | 5.40 | 1.1 | 160 | 11.5 | 4.5 | Δ | ◎ | Δ |
| Comp. Ex. 2 | Sn +Ti + B (6, 2) | 40 | - | - | 40 | 0.58 | 2.0 | 16.0 | 11.0 | 50 | ◎ | × | × |
| Comp. Ex. 3 | Sn +Ti (20, 0) | 40 | - | - | 40 | 0.02 | 3.5 | 16.0 | 10.5 | 5.5 | ◎ | × | × |
| Ref. Ex. | TaO (Upper layer) 2 nm TaN (Lower layer) 58 nm | 60 | - | - | 60 | 1.83 | 1.5 | 16.0 | 8.7 | 7.3 | Δ | ◎ | Δ |

As shown in Table 1, it was found from the evaluation results of Examples 1 to 18 and Comparative Examples 1 to 3 that, when the absorption film has Sn/M of 1 or more as in Examples 1 to 18, the reflectance is lower than that when the absorption film has Sn/M of less than 1 as in Comparative Example 1, and the shadowing effect can be reduced.

It was also found from the evaluation results of Examples 1 to 9, 16, 18 and Comparative Example 3 that, when Sn/M is less than 20 as in Examples 1 to 9, 16, 18, the hydrogen radical resistance is higher than that when Sn/M is 20 or more as in Comparative Example 3.

Further, it was found from the evaluation results of Example 9 and Examples 10 to 13, 17 that, when the metalloid elements are contained, the hydrogen radical resistance is improved by stably forming the oxide coating even when Sn/M is large.

It was also found that the hydrogen radical resistance in Examples 10 to 13 is higher than that when L/M is larger than 1 as in Comparative Example 2.

It was also found from the evaluation results of Examples 14 and 15 that, even when the element other than Sn and the metal elements and the metalloid elements mentioned above, such as oxygen, is contained, the hydrogen radical resistance is high when the oxide coating is formed.

The reflective mask and the method for producing a reflective mask of the present disclosure are not limited to the embodiment and Examples described above and can be variously modified without impairing the features of the invention.

Reference Signs List

11: substrate
12: multi-layer reflective film
13: protective film
14: absorption film
14a: absorption film pattern
15: oxide coating
16: back surface conductive film
17: resist film
100: reflective photomask (reflective mask)
200: reflective photomask blank (reflective mask blank)
300: chamber
301: electrode
302: sample

**Claims**

1. A reflective mask comprising:

    a substrate;
    a reflective film configured to reflect an EUV light having a multi-layer film structure formed on the substrate;
    a protective film formed on the reflective film, and configured to protect the reflective film;
    an absorption film configured to absorb the EUV light formed on the protective film; and
    an oxide coating formed on the absorption film;
    wherein
    the absorption film contains Sn and a metal element other than Sn and has a ratio of an atomic weight of the Sn to a total atomic weight of the metal element other than Sn (Sn/Metal element other than Sn) within a range of 1 or more and less than 20, and
    the oxide coating is resistant to a hydrogen radical and formed on a surface and side surfaces of the absorption film.

2. A reflective mask comprising:

    a substrate;
    a reflective film configured to reflect an EUV light having a multi-layer film structure formed on the substrate;
    a protective film formed on the reflective film, and configured to protect the reflective film;

an absorption film configured to absorb the EUV light formed on the protective film; and
an oxide coating formed on the absorption film;
wherein
the absorption film contains Sn in a proportion of 50 at% or more, and
the oxide coating is resistant to a hydrogen radical and formed on a surface and side surfaces of the absorption film.

3. The reflective mask according to claim 1 or 2, wherein the oxide coating contains a compound containing at least one of oxides of Cr, Ta, Nb, Ti, Al, V, and Hf.

4. The reflective mask according to any one of claims 1 to 3, wherein the oxide coating does not contain Sn or the oxide coating contains Sn, and a content of the Sn is smaller than a content of the compound containing at least one of oxides of Cr, Ta, Nb, Ti, Al, V, and Hf.

5. The reflective mask according to any one of claims 1 to 4, wherein the absorption film contains a compound containing at least one of Cr, Ta, Nb, Ti, Al, V, and Hf as the metal element other than Sn.

6. The reflective mask according to any one of claims 1 to 5, wherein the oxide coating has a film thickness of 1 nm or more.

7. The reflective mask according to any one of claims 1 to 6, wherein the absorption film does not contain B, C, P, Si, and Ge, which are metalloid elements, or contains at least one of the metalloid elements, and has a ratio of a total atomic weight of the metalloid element to a total atomic weight of the metal element other than Sn (Metalloid element/Metal element other than Sn) within a range of 0 or more and 1 or less.

8. The reflective mask according to any one of claims 1 to 7, wherein the absorption film contains the compound containing at least one of Cr, Ta, Nb, Ti, Al, V, and Hf in a proportion of more than 5 at%.

9. The reflective mask according to any one of claims 1 to 8, wherein the absorption film is able to be etched with a fluorine-based gas or a chlorine-based gas.

10. The reflective mask according to any one of claims 1 to 9, wherein a total film thickness of the absorption film and the oxide coating is 45 nm or less, and an OD value (Optical Density) is 1.0 or more.

11. A method for producing a reflective mask, the reflective mask including:

a substrate;
a reflective film configured to reflect an EUV light having a multi-layer film structure formed on the substrate;
a protective film configured to protect the reflective film formed on the reflective film;
an absorption film configured to absorb the EUV light formed on the protective film; and
an oxide coating formed on the absorption film;
wherein
the absorption film contains Sn and a metal element other than Sn and has a ratio of an atomic weight of the Sn to a total atomic weight of the metal element other than Sn (Sn/Metal element other than Sn) within a range of 1 or more and less than 20, and
the oxide coating is resistant to a hydrogen radical and formed on a surface and side surfaces of the absorption film.

12. A method for producing a reflective mask, the reflective mask including:

a substrate;
a reflective film configured to reflect an EUV light having a multi-layer film structure formed on the substrate;
a protective film configured to protect the reflective film formed on the reflective film;
an absorption film configured to absorb the EUV light formed on the protective film; and
an oxide coating formed on the absorption film;
wherein
the absorption film contains Sn in a proportion of 50 at% or more, and
the oxide coating is resistant to a hydrogen radical and formed on a surface and side surfaces of the absorption film.

13. The method for producing a reflective mask according to claim 11 or 12, wherein the oxide coating is formed by oxidizing the absorption film.

# FIG. 1

FIG. 2

EP 4 231 094 A1

# FIG. 3

| Generator MWP 2.45GHz |
|---|

300

301

HYDROGEN PLASMA

H₂

302

301

# FIG. 4

17

14

13

12

11

16

200

# FIG. 5

# FIG. 6

# FIG. 7

14a
13
12
11
16

# FIG. 8

15
14a
13
12
100
11
16

## INTERNATIONAL SEARCH REPORT

| International application No. |
| --- |
| **PCT/JP2021/037350** |

**A.    CLASSIFICATION OF SUBJECT MATTER**

*G03F 1/24*(2012.01)i; *C23C 14/14*(2006.01)i
FI:    G03F1/24; C23C14/14 D

According to International Patent Classification (IPC) or to both national classification and IPC

**B.    FIELDS SEARCHED**

Minimum documentation searched (classification system followed by classification symbols)

G03F1/24; C23C14/14

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| X | JP 2019-56898 A (AGC INC.) 11 April 2019 (2019-04-11)<br>    paragraphs [0016]-[0057], [0105]-[0110], fig. 2, 3 | 1-13 |
| A | JP 2010-192503 A (SEIKO EPSON CORP.) 02 September 2010 (2010-09-02)<br>    entire text, all drawings | 1-13 |
| A | JP 2003-318104 A (SAMSUNG ELECTRONICS CO., LTD.) 07 November 2003<br>(2003-11-07)<br>    entire text, all drawings | 1-13 |

☐ Further documents are listed in the continuation of Box C.          ☑ See patent family annex.

| | |
| --- | --- |
| *    Special categories of cited documents:<br>"A"    document defining the general state of the art which is not considered to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
| --- | --- |
| **21 October 2021** | **02 November 2021** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2021/037350**

| Patent document cited in search report | | | Publication date (day/month/year) | Patent family member(s) | Publication date (day/month/year) |
|---|---|---|---|---|---|
| JP | 2019-56898 | A | 11 April 2019 | US 2019/0086791 A1 paragraphs [0031]-[0073], [0121]-[0126], fig. 2, 3 KR 10-2019-0033444 A | |
| JP | 2010-192503 | A | 02 September 2010 | (Family: none) | |
| JP | 2003-318104 | A | 07 November 2003 | US 2003/0198874 A1 entire text, all drawings KR 10-2003-0082819 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018159785 A